# FASCICULE DE BREVET EUROPEEN

(11) **EP 1 444 776 B1**
(45) Date de publication et mention de la délivrance du brevet: **12.12.2012**
(21) Numéro de dépôt: 02762202.6
(22) Date de dépôt: 30.09.2002
(51) Int. Cl.: H03F 3/30

(54) **AMPLIFICATEUR DE PUISSANCE**
LEISTUNGSVERSTÄRKER
POWER AMPLIFIER

(30) Priorité: 15.11.2001 CH 214701
(43) Date de publication de la demande: 11.08.2004
(73) Titulaire: Deletraz, Hervé, 1213 Petit-Lancy (CH)
(72) Inventeur: Deletraz, Hervé, 1213 Petit-Lancy (CH)
(86) Numéro de dépôt international: PCT/CH2002/000541
(87) Numéro de publication internationale: WO 2003/043185

(56) Documents cités:
- EP-A- 0 673 111
- US-A- 4 833 423

## Description

La présente invention a pour objet un amplificateur de puissance hi-fi à transistors bipolaires pour fréquences audio.

Il existe de nombreux amplificateurs à étages susceptibles d'être utilisés comme amplificateurs de puissance. Le brevet US N° 4,833,423 décrit un amplificateur à transistors comprenant plusieurs étages, en particulier quatre étages.

Le problème posé par ce type d'amplificateur réside dans des fluctuations internes dues à une élévation de la température, et à des contre-réactions internes au circuit.

Des explications sur le fonctionnement des amplificateurs à étages se retrouvent dans la publication « Halbleiter-Schaltungstechnik » éditée en 1986 chez Springer-Verlag, Berlin.

L'amplificateur selon l'invention comprend trois étages ; ses caractéristiques sont les suivante :
- Bande passante très étendue liée à un déphasage négligeable.
- Reproduction dynamique absente de déformations transitoire.
- Délai de propagation de groupes linéaire sur toute la plage de fréquences.
- Immunité importante vis-à-vis des phénomènes électrostatiques.
- Excellente fiabilité vu le petit nombre de composants électroniques.

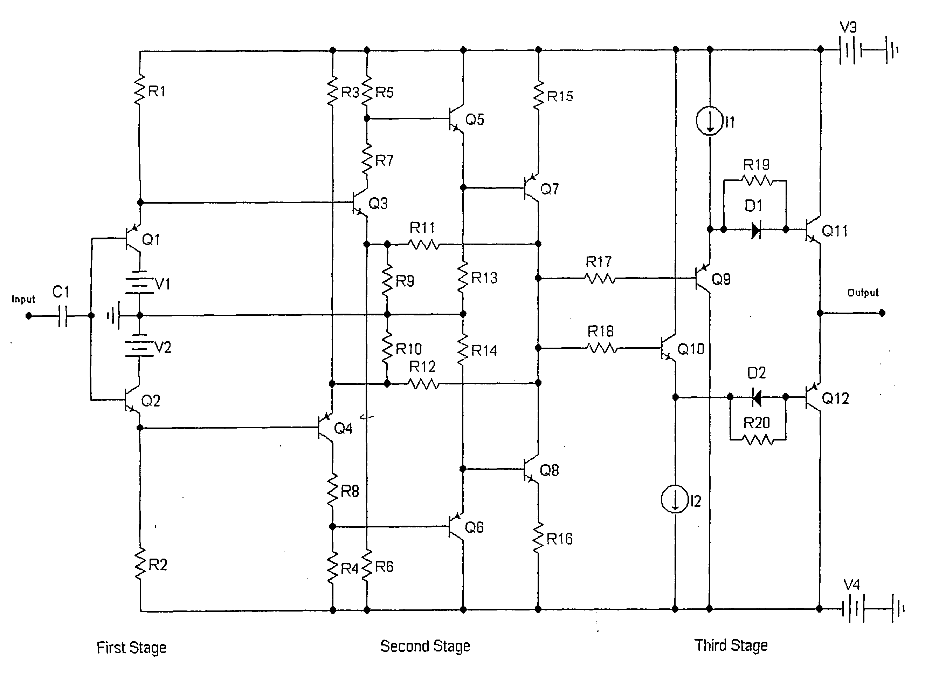

La figure unique du dessin ci-annexé est le schéma électrique d'une forme d'exécution non limitative d'un amplificateur de puissance selon l'invention. L'amplificateur schématisé est constitué par trois étages.

Le premier étage comprend deux transistors bipolaires Q1 et Q2 polarisés en classe A symétriques et deux résistances R1 et R2 permettant d'adapter l'impédance d'entrée à la source. Sa bande passante est très étendue. Il fonctionne en boucle ouverte avec une rotation de phase faible à un seul pôle. Sa très faible capacité d'entrée permet une réponse linéaire en fréquence même si la source est à haute impédance.

Le deuxième étage comprend six transistors bipolaires Q3, Q4, Q5, Q6, Q7, Q8 et des résistances R3 ... R18.

Son gain en tension est déterminé par les deux-demis contre-réactions négatives, en courant continu et symétriques, formées par les résistances R9/R11 et R10/R12. Les transistors Q3 et Q4 effectuent une première amplification en tension, puis sont tamponnés par les transistors Q5 et Q6. Le signal est ensuite amplifié une seconde fois en puissance par les transistors Q7 et Q8 connectés en collecteur commun.

Dans ce deuxième étage le signal est donc amplifié successivement comme suit : une fois en tension, une fois en courant et une troisième fois en puissance. Cette disposition permet d'élever le signal « en douceur » jusqu'au niveau requis par l'étage suivant.

Ce deuxième étage présente un gain linéaire en boucle ouverte, une faible impédance de sortie, et une vitesse de propagation élevée garantissant un comportement transitoire linéaire et exempt de distorsion dynamique.

Le troisième étage comprend quatre transistors Q9, Q10, Q11 et Q12 polarisés en classe AB, deux résistances R19 et R20, et deux diodes D1 et D2. Les transistors Q9 et Q10, qui sont alimentés par une source de courant, provoquent une chute de tension V_{BE} aux bornes des transistors Q11 et Q12, directement proportionnelle à la chute de tension V_{BE} aux bornes des transistors Q9 et Q10.

Le courant de repos circulant à travers les transistors Q11 et Q12, engendré par leur tension VBE est donc directement dépendant de la tension VBE des transistors Q9 et Q10.

Ce montage constitue une simplification du circuit traditionnel de polarisation améliorant ainsi les caractéristiques statique et dynamique de cet étage par rapport aux étages correspondants connus.

Les résistances R19 et R20 permettent d'agir directement sur la plage de fonctionnement (classes A, AB ou B) suivant le type d'application recherché.

Les diodes D1 et D2 assurent une réponse aux impulsions très rapide grâce à leur capacité de jonction PN et protègent les résistances R19 et R20 contre tout échauffement.

Ce troisième étage, qui constitue une nouveauté en soi, est électriquement et thermiquement stable et sa très faible impédance de sortie permet un fonctionnement en boucle ouverte.

La combinaison de ces trois étages permet de réaliser des amplificateurs de puissance présentant les particularités et avantages suivants :
- capacité de montage
- adaptabilité à diverses applications telles que pré-amplificateur de microphone et pré-amplificateur phono à faible bruit
- fonctionnement sans distorsion sur de très larges plages de tension
- répétitivité des caractéristiques lors de fabrication en série
- procédures de tests réduites au minimum
- disponibilité des composants électroniques
- maintenance facile
- reproduction inégalée des attaques
- dynamique reproduite sans aucune compression
- image sonore de haute fidélité

L'invention n'est évidemment pas limitée au schéma représenté et à l'application décrite.

En particulier d'autres applications peuvent être envisagées notamment grâce à l'extrême vitesse du circuit.

Par exemple en informatique pour le positionnement rapide et fiable des têtes d'enregistrement des disques durs. Le temps d'établissement très court est obtenu, dans ce cas, sans oscillation parasite, et la position désirée est atteinte sans erreur. Une miniaturisation du circuit le rendrait encore plus rapide.

Toujours en informatique, sa faible impédance de sortie permet de l'utiliser pour la transmission de données sur de grandes longueurs à vitesse élevée. On pourrait ainsi augmenter considérablement la distance standard (100 m.) pour les liaisons câblées.

En informatique et en industrie électronique, il peut être utilisé, grâce à sa vitesse élevée de commutation, pour l'alimentation à découpage de très hautes fréquences.

Sa grande impédance d'entrée alliée à une capacité très basse le rend très facile à commander.

Ces applications sont non exhaustives et tout système nécessitant précision, haute vitesse et/ou immunité aux agents extérieurs, peut bénéficier de ce circuit « universel ».

## Revendications

1. Amplificateur de puissance, hi-fi, à transistors bipolaires, pour fréquences audio, **caractérisé par le fait qu'**il est composé de trois étages :
■ un premier étage (Q1, V1 ; Q2, V2) dépourvu de contre-réaction, amplifiant en courant le signal d'entrée,
■ un deuxième étage (Q3 à Q8) amplifiant en tension le signal sortant du premier étage et comprenant deux demi circuits de contre-réaction (R9, R11 ; R10, R12), en courant continu, électriquement connectés de façon symétrique par rapport aux tensions d'alimentation et opérant sur tout le spectre de fréquences,
■ un troisième étage, (Q9 à Q12), dépourvu de contre-réaction, amplifiant le courant issu du deuxième étage et permettant d'alimenter un haut-parleur, comprenant des transistors «driver» (Q9, Q10) et des transistors de sortie (Q11, Q12), le courant de repos des transistors de sortie *(Q11 et Q12)* étant réalisé par la tension de jonction *base-émetteur des transistors « driver » (Q9 et Q10).*

2. Amplificateur selon la revendication 1, **caractérisé par le fait que** son premier étage comprend deux transistors bipolaires (Q1, Q2) polarisés en classe A, symétriques et deux résistances (R1, R2).

3. Amplificateur selon la revendication 1, **caractérisé par le fait que** son deuxième étage comprend six transistors bipolaires ( Q3, Q8) et des résistances (R3, R18), les demi circuits de contre réaction électriquement connectés de façon symétrique par rapport aux tensions d'alimentation comportant deux paires de résistances (R9 / R11 et R10 /R12).

4. Amplificateur selon la revendication 1, **caractérisé par le fait que** son troisième étage comprend quatre transistors bipolaires (Q9, Q10, Q11, Q12) polarisés en classe AB et deux résistances (R19, R20), permettant notamment d'agir en courant et en tension sur la plage de fonctionnement.

5. Amplificateur selon la revendication 4, **caractérisé par le fait que** son troisième étage comprend deux diodes (D1, D2) protégeant les résistances (R19, R20), et permettant d'agir en courant et en tension sur la plage de fonctionnement contre tout échauffement.

## Claims

1. Power amplifier, hi-fi, with bipolar transistors, for audio frequencies, **characterised by** the fact that it consists of three stages:
■ a first stage (Q1, V1; Q2, V2) without feedback, amplifying the input signal in terms of current,
■ a second stage (Q3 A Q8) amplifying the signal passed from the first stage in terms of voltage and consisting of two feedback half-circuits (R9, R11; R10, R12), in direct current, *electrically connected symmetrically in relation to the power voltages* and operating on the full spectrum of frequencies,
■ a third stage, (Q9 to Q12), without feedback, amplifying the current derived from the second stage and enabling a loudspeaker to be powered, *including "driver" transistors (Q9, Q10) and output transistors (Q11, Q12)*, the quiescent current of the output transistors (011 an 012) being implemented by the *"driver" transistors (Q9 and 010) base-emitter* junction voltage.

2. Amplifier according to claim 1, **characterised by** the fact the its first stage consists of two bipolar transistors (Q1, Q2) polarised in class A, symmetrical, and two resistances (RI, R2).

3. Amplifier according to claim 1, **characterised by** the fact that its second stage consists of six bipolar transistors (Q3, Q8) and resistances (R3, R18), the feedback half-circuits *electrically connected symmetrically in relation to the power voltages* including two pairs of resistances (R9 / R21 and R10 / R12).

4. Amplifier in accordance with claim 1, **characterised by** the fact that its third stage consist of four bipolar transistors (Q9, Q10, 011, Q12) polarised in class AB and two resistances (R19, R20), in particular enabling an action in terms of current and voltage on the functioning range.

5. Amplifier according to claim 4, **characterised by** the fact that its third stage includes two diodes (D1, D2) protecting the resistances (R19, R20), and enabling action in terms of current and voltage on the functioning range, preventing any heating effect.

## Patentansprüche

1. Hi-Fi-Leistungsverstärker mit bipolaren Transistoren für Audiofrequenzen, **dadurch gekennzeichnet, dass** er aus drei Stufen besteht:
■ einer ersten rückkopplungsfreien Stufe (Q1, V1 ; Q2, V2), durch die eine Stromverstärkung des Eingangssignals erfolgt,
■ einer zweiten Stufe (Q3 bis Q8), durch die eine Spannungsverstärkung des Ausgangssignals der ersten Stufe erfolgt und die zwei Gleichstrom-Rückkopplungshalbschaltungen (R9, R11; R10, R12) beinhaltet, die symmetrisch in Relation zu den Speisespannungen elektrisch angeschlossen sind und über das gesamte Frequenzspektrum abbilden,
■ einer dritte rückkopplungsfreie Stufe (Q9 bis Q12), durch die der Stromausgang der zweiten Stufe verstärkt wird und die es erlaubt, einen Lautsprecher zu speisen, wobei sie zwei Treibertransistoren (Q9, Q10) und zwei Endstufentransistoren (Q11, Q12) beinhaltet und der Ruhestrom der Endstufentransistoren (Q11 und Q12) durch die Spannung am Übergang zwischen Basis und Emitter der Treibertransistoren (Q9 und Q10) realisiert wird.

2. Verstärker nach Anspruch 1, **dadurch gekennzeichnet, dass** seine erste Stufe zwei Class-A-vorgespannte bipolare Transistoren (Q1/ Q2) mit symmetrischer Signalverarbeitung und zwei Widerständen (RI, R2) beinhaltet.

3. Verstärker nach Anspruch 1, **dadurch gekennzeichnet, dass** seine zweite Stufe sechs bipolare Transistoren ( Q3 bis Q8) und Widerstände (R3 bis R18) beinhaltet, wobei die Rückkopplungshalbschaltungen symmetrisch in Relation zu den Speisespannungen elektrisch angeschlossen sind, die zwei Widerstandspaare beinhalten (R9 / R11 und R10 / R12).

4. Verstärker nach Anspruch 1, **dadurch gekennzeichnet, dass** seine dritte Stufe vier Class-AB-vorgespannte bipolare Transistoren (Q9, Q10, Q11, Q12) und zwei Widerstände (R19, R20) beinhaltet, so dass es möglich ist, insbesondere unter Strom und unter Spannung auf den Betriebsbereich einzuwirken.

5. Verstärker nach Anspruch 4, **dadurch gekennzeichnet, dass** seine dritte Stufe zwei Dioden (D1, D2) beinhaltet, die die Widerstände (R19, R20) schützen, so dass es möglich ist, unter Strom und unter Spannung auf den Betriebsbereich gegen jede Erwärmung einzuwirken.
